# EUROPEAN PATENT APPLICATION

(11) **EP 4 372 130 A1**
(43) Date of publication of application: **22.05.2024**
(21) Application number: 22841918.0
(22) Date of filing: 27.06.2022
(51) Int. Cl.: C30B 29/38, H01L 21/02, H01L 21/20, H01L 21/205, H01L 21/265, H01L 33/32

(54) **EPITAXIAL WAFER FOR ULTRAVIOLET LIGHT EMITTING ELEMENT AND METHOD FOR MANUFACTURING SAME**

(30) Priority: 16.07.2021 JP 2021117554
(71) Applicant: Shin-Etsu Handotai Co., Ltd., Tokyo 100-0004 (JP); SHIN-ETSU CHEMICAL CO., LTD., Tokyo 1000005 (JP)
(72) Inventor: TSUCHIYA, Keitaro, Annaka-shi, Gunma 379-0196 (JP); YAMADA, Masato, Tokyo 100-0004 (JP); NAGATA, Kazutoshi, Annaka-shi, Gunma 379-0195 (JP)
(74) Representative: Sonnenhauser, Thomas Martin
(86) International application number: PCT/JP2022/025480
(87) International publication number: WO 2023/286574

(57) **Abstract**

The present invention is an epitaxial wafer for an ultraviolet ray emission device including: a first supporting substrate being transparent for ultraviolet ray and having heat resistance; a seed crystal layer of an AlₓGa₁₋ₓN (0.5<x≤1) single crystal bonded on the first supporting substrate by laminating; and an epitaxial layer on the seed crystal layer, the epitaxial layer having: a first conductive clad layer containing Al_{y}Ga_{1-y}N (0.5<y≤1) as a main component; an AlGaN-based active layer; and a second conductive clad layer containing Al_{z}Ga_{1-z}N (0.5<z≤1) as a main component that are stacked and grown in this order. The present invention provides: an inexpensive epitaxial wafer for an ultraviolet ray emission device having good light extraction efficiency and high quality and having an epitaxial layer of a III-group nitride such as AlN; and a method for manufacturing the same.

## Description

### TECHNICAL FIELD

The present invention relates to an epitaxial wafer for an ultraviolet ray emission device and a method for manufacturing the same.

### BACKGROUND ART

Deep ultraviolet ray emitting diodes utilizing a nitride-based semiconductor material have been expected to enlarge their market in recent years as a light source for sterilization from the viewpoints of mercury-free, long lifetime, size reduction, weight reduction, energy saving, etc.

However, for an epitaxial substrate for these deep ultraviolet ray emitting diodes, an AlN layer is grown on a sapphire substrate or an AlN substrate as a base substrate by a hydride vapor phase epitaxy (HVPE) method (Patent Document 1). When the AlN layer is formed on a material substrate having a different lattice constant, such as sapphire and SiC, defects due to the lattice mismatching are generated to tend to drop internal quantum efficiency and decrease energy conversion efficiency.

When the wavelength is shorter than 250 nm, the above effect becomes more considerable.

A GaN single crystal free-standing substrate, which has a relatively close lattice constant, becomes a light absorbent substrate due to its bandgap to decrease external quantum efficiency. Although an AlN single crystal free-standing substrate is promising as an extremely high-quality epitaxial substrate, it is difficult to manufacture the substrate, and the substrate is an extremely expensive material. Thus, the spread of the deep ultraviolet ray emitting diode for sterilization with high output and high efficiency has been problematic.

### CITATION LIST

### PATENT LITERATURE

Patent Document 1: JP 6042545 B

### SUMMARY OF INVENTION

### TECHNICAL PROBLEM

To produce an inexpensive and high-quality deep ultraviolet ray emitting diode, it is considered to use a substrate composed of AlN ceramic to produce the deep ultraviolet ray emitting diode.

However, since the AlN ceramic substrate is not transparent, it is difficult to extract light from the substrate side.

The present invention has been made in view of the above circumstances. An object of the present invention is to provide: an inexpensive epitaxial wafer for an ultraviolet ray emission device having an epitaxial layer of a III-group nitride, such as AlN, with good light extraction efficiency and high quality; and a method for manufacturing the same.

### SOLUTION TO PROBLEM

To achieve the above object, the present invention provides an epitaxial wafer for an ultraviolet ray emission device, comprising:
a first supporting substrate being transparent for ultraviolet ray and having heat resistance;
a seed crystal layer of an AlₓGa₁₋ₓN (0.5<x≤1) single crystal bonded on the first supporting substrate by laminating; and
an epitaxial layer on the seed crystal layer, the epitaxial layer having: a first conductive clad layer containing Al_{y}Ga_{1-y}N (0.5<y≤1) as a main component; an AlGaN-based active layer; and a second conductive clad layer containing Al_{z}Ga_{1-z}N (0.5<z≤1) as a main component that are stacked and grown in this order.

Such an epitaxial wafer for an ultraviolet ray emission device can extract light from the substrate side, and thereby yields high quality with improved light extraction efficiency.

In addition, since the seed crystal layer is bonded by laminating, the seed substrate of the expensive nitride semiconductor single crystal separated by laminating can be regenerated for use, for example, and a material cost in the entire process can be remarkably reduced. As a result, the inventive epitaxial water becomes inexpensive.

A main component of the first supporting substrate may be synthetic quartz or sapphire.

Since ceramics used as a material for a first supporting substrate in a conventional product are produced by molding and sintering a powder raw material, voids are easily generated on the surface. The voids are filled and polished in a planarizing step (CVD and polishing), but it is difficult to completely eliminate the voids. The void parts on the ceramics sink to loss crystallinity of the seed crystal layer, and thereby there is a concern of formation of defects to decrease an yield. However, the aforementioned material is relatively inexpensive, and can more certainly yield a wafer being transparent for ultraviolet ray, having small surface roughness, and causing no deformation, breakage, nor volatilization due to high temperature. That is, compared with the conventional product in which the first supporting substrate is the ceramic substrate and defects are easily generated, the inventive wafer is an epitaxial wafer for an ultraviolet ray emission device with furthermore inexpensiveness, improved crystallinity, and high quality.

The AlGaN-based active layer may be formed with MQW structure and may contain In at a proportion of less than 1% as a constituent element other than Al, Ga, and N.

Such formation with the MQW structure promotes recombination to improve the internal quantum efficiency.

The AlGaN-based active layer may exhibit a peak wavelength λ_{ρ} shorter than 235 nm in an emission spectrum with current injection at 25°C and 0.2 A/mm².

The AlGaN-based active layer having such a peak wavelength yields the epitaxial wafer for an ultraviolet ray emission device particularly useful as a light source for sterilization.

A bandgap of the seed crystal layer may be larger than a bandgap of the AlGaN-based active layer.

Such a configuration can more certainly prevent absorption of light by the seed crystal layer on the substrate side.

An epitaxial growth surface in the seed crystal layer may be a C-plane.

Such an epitaxial growth surface facilitates the crystal growth to yield a thin film with good quality.

The present invention also provides a method for manufacturing an epitaxial wafer for an ultraviolet ray emission device, the method comprising steps of: producing a laminated substrate by laminating a seed crystal layer on a first supporting substrate being transparent for ultraviolet ray and having heat resistance, the seed crystal layer being peel-transferred from an AlₓGa₁₋ₓN (0.5<x≤1) single crystal; and forming an epitaxial layer on the laminated substrate, the epitaxial layer having: a first conductive clad layer containing Al_{y}Ga_{1-y}N (0.5<y≤1) as a main component; an AlGaN-based active layer; and a second conductive clad layer containing Al_{z}Ga_{1-z}N (0.5<z≤1) as a main component that are epitaxially grown in this order.

Such a manufacturing method can manufacture the inexpensive epitaxial wafer for an ultraviolet ray emission device that can extract light from the substrate side and that has high quality with improved light extraction efficiency.

A main component of the first supporting substrate may be synthetic quartz or sapphire.

Such a configuration is relatively inexpensive, and can more certainly yield the wafer being transparent for ultraviolet ray, having small surface roughness, and causing no deformation, breakage, nor volatilization due to high temperature. Therefore, the epitaxial wafer for an ultraviolet ray emission device can be yielded with furthermore inexpensiveness, improved crystallinity, and high quality.

The AlGaN-based active layer may be formed with MQW structure and may contain In at a proportion of less than 1% as a constituent element other than Al, Ga, and N.

Such formation with the MQW structure promotes recombination to improve the internal quantum efficiency.

The AlGaN-based active layer may exhibit a peak wavelength λₚ shorter than 235 nm in an emission spectrum with current injection at 25°C and 0.2 A/mm².

With the AlGaN-based active layer having such a peak wavelength, the epitaxial wafer for an ultraviolet ray emission device particularly useful as a light source for sterilization can be manufactured.

A bandgap of the seed crystal layer may be larger than a bandgap of the AlGaN-based active layer.

Such a configuration can more certainly prevent absorption of light by the seed crystal layer on the substrate side.

An epitaxial growth surface in the seed crystal layer may be a C-plane.

Such a configuration can facilitate the crystal growth to yield a thin film with good quality.

### ADVANTAGEOUS EFFECTS OF INVENTION

The inventive epitaxial wafer for an ultraviolet ray emission device and method for manufacturing the same can yield the epitaxial wafer of an inexpensive ultraviolet ray emitting diode with high light extraction efficiency and high quality.

### BRIEF DESCRIPTION OF DRAWINGS

FIG. 1 is a schematic view illustrating an example of the inventive epitaxial wafer for an ultraviolet ray emission device.
FIG. 2 is a schematic view illustrating an example of an ultraviolet ray emission device layer.
FIG. 3 is a process flow illustrating an example of the inventive method for manufacturing an epitaxial wafer for an ultraviolet ray emission device.

### DESCRIPTION OF EMBODIMENTS

Hereinafter, embodiments of the present invention will be described with reference to the drawings, but the present invention is not limited thereto.

As noted above, there have been demands of an inexpensive and high-quality epitaxial wafer suitable for an emitting diode for an ultraviolet ray region (specifically, deep ultraviolet ray region (UVC: 200 to 290 nm)).

The inventors have made earnest study, and consequently found that the inexpensive and high-quality epitaxial wafer with good light extraction efficiency can be provided by an epitaxial wafer comprising: a first supporting substrate being transparent for ultraviolet ray and having heat resistance; a seed crystal layer of an AlₓGa₁₋ₓN (0.5<x≤1) single crystal bonded on the first supporting substrate by laminating; and an epitaxial layer on the seed crystal layer, the epitaxial layer having: a first conductive clad layer containing Al_{y}Ga_{1-y}N (0.5<y≤1) as a main component; an AlGaN-based active layer; and a second conductive clad layer containing Al_{z}Ga_{1-z}N (0.5<z≤1) as a main component that are stacked and grown in this order. This finding has led to complete the present invention.

Hereinafter, the description will be made with reference to the drawings.

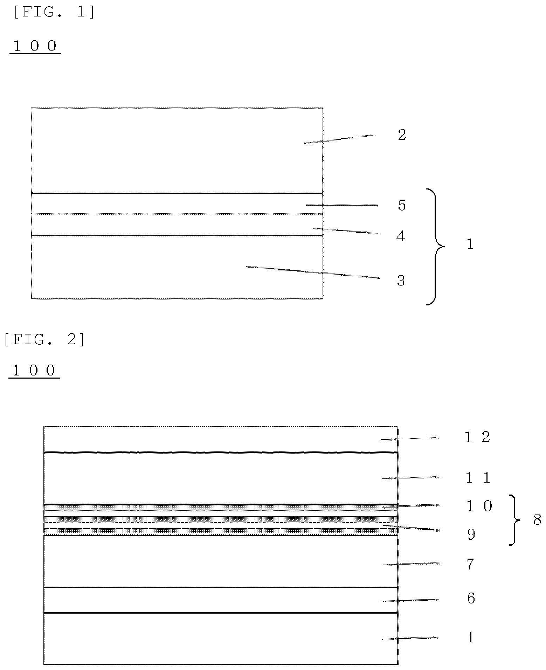

The inventive epitaxial wafer 100 for an ultraviolet ray emission device illustrated in FIG. 1 has a substrate produced by laminating (laminated substrate 1) and an ultraviolet ray emission device layer 2 composed of a nitride semiconductor.

The laminated substrate 1 has a first supporting substrate 3, an adhesion layer 4, and a seed crystal layer 5, and the seed crystal (seed crystal layer 5) is laminated and bonded on the first supporting substrate 3. Here, the first supporting substrate 3 and the seed crystal layer 5 are bonded by the adhesion layer 4 for manufacturing the laminated substrate 1.

A material, etc. of the first supporting substrate 3 are not particularly limited as long as it is transparent for ultraviolet light and has heat resistance. For example, usable is a substrate having a light transmittance at a wavelength of 230 nm of at least 70% or more, and having heat resistance of no melting, peeling, nor breakage in a treatment at high temperature exceeding 1000°C. As more specific examples thereof, a substrate containing synthetic quartz or sapphire as a main component may be used. In particular, the substrate may be a synthetic quartz substrate or a sapphire substrate. These substrates are inexpensive and have small surface roughness compared with the conventional substrates made of ceramics. Thus, loss of the crystallinity of the seed crystal layer 5 bonded by laminating can be prevented. As a result, the seed crystal layer 5, further the ultraviolet ray emission device layer 2, can have higher quality, and yield the excellent epitaxial wafer for an ultraviolet ray emission device.

The seed crystal layer 5 composed of an AlₓGa₁₋ₓN (0.5<x≤1) single crystal can be produced on the first supporting substrate 3 by, for example, preparing an AlₓGa₁₋ₓN (0.5<x≤1) single crystal free-standing substrate or an AlₓGa₁₋ₓN (0.5<x≤1) epitaxial substrate (seed substrate), implanting ions into the substrate to form a fragile layer, laminating the seed substrate to the first supporting substrate 3, and then peel-transferring at the fragile layer. The method is not limited thereto.

Since the seed crystal layer 5 is formed by such laminating, the aforementioned free-standing substrate, etc. of the lamination master (namely, the seed substrate separated by peeling the seed crystal layer 5) can be repeatedly used as a seed crystal layer for producing another inventive epitaxial wafer for an ultraviolet ray emission device by surface polishing to form an ion implanting surface. As above, the relatively expensive AlₓGa₁₋ₓN (0.5<x≤1) single crystal substrate can be repeatedly and effectively used, and thereby the overall cost can be reduced and the seed crystal layer 5 and the inventive epitaxial wafer 100 for an ultraviolet ray emission device consequently become inexpensive.

Furthermore, a bandgap of the seed crystal layer 5 is preferably larger than a bandgap of an AlGaN-based active layer, described later. This is because light absorption in the seed crystal layer 5 is prevented to extract light more certainly and more efficiently. From the viewpoint of this light absorption prevention, a larger bandgap of the seed crystal layer 5 is better, and the upper limit is undecidable. An epitaxial growth surface in the seed crystal layer 5 is preferably a C-plane. Such an epitaxial growth surface facilitates the crystal growth to yield a thin film (ultraviolet ray emission device layer 2) with high quality.

The adhesion layer 4 bonds the first supporting substrate 3 and the seed crystal layer 5, and may be a layer being transparent for ultraviolet ray, such as SiO₂, for example.

Alternatively, the laminated substrate 1 may not be bonded by such an adhesion layer 4 but may be bonded by activating the surface of the AlGaN single crystal to be the seed crystal layer 5 with plasma or argon-ion etching to form an amorphous layer and by laminating the layer to the first supporting substrate 3 with a pressurizing and heating method.

On the laminated substrate 1, the ultraviolet ray emission device layer 2 is vapor-phase grown. FIG. 2 illustrates an outline of an example of the ultraviolet ray emission device layer 2. Hereinafter, construction of the ultraviolet ray emission device layer will be described in detail.

A homoepitaxial layer 6 is epitaxially grown on the laminated substrate 1. The homoepitaxial layer is introduced in order to improve the crystal quality, and may be designed within a range of a thickness of 100 nm to 500 nm. The homoepitaxial layer may be omitted depending on device design.

The first conductive clad layer 7 (containing Al_{y}Ga_{1-y}N (0.5<y≤1) as a main component) is formed in order to supply electrons to the AlGaN-based active layer 8. The film thickness is not particularly limited, and may be 2.5 µm, for example.

The AlGaN-based active layer 8 has quantum well structure, and barrier layers 9 and well layers 10 are alternately laminated (MQW structure). For example, In may be present as a constituent element other than Al, Ga, and N, and a proportion of the In may be more than 0% and less than 1%. Such a configuration is preferable because internal quantum efficiency is improved to achieve more efficient light emission. The AlGaN-based active layer 8 may exhibit a peak wavelength λₚ shorter than 235 nm in an emission spectrum with current injection at 25°C and 0.2 A/mm². Such a configuration can yield light, particularly light in a deep ultraviolet ray region, more certainly, and is useful as a light source for sterilization. A lower limit of this peak wavelength λₚ in the deep ultraviolet ray region of the emission spectrum may be, for example, 200 nm. The film thickness is not particularly limited, and a three-layered laminate in which the barrier layer thickness is 6 nm and the well layer thickness is 1.5 nm may be formed, for example.

The second conductive clad layer 11 (containing Al_{z}Ga_{1-z}N (0.5<z≤1) as a main component) is formed in order to supply positive holes to the AlGaN-based active layer 8. The film thickness is not particularly limited, and may be 30 nm, for example.

These layers are laminated in order by epitaxial growth.

To reduce contacting resistance with an electrode, a p-type AlGaN contact layer 12 is formed. The film thickness is not particularly limited, and may be 60 nm, for example. In the present epitaxial wafer, the layer disposition may be converted P/N depending on the conductive type of the second conductive clad layer 11.

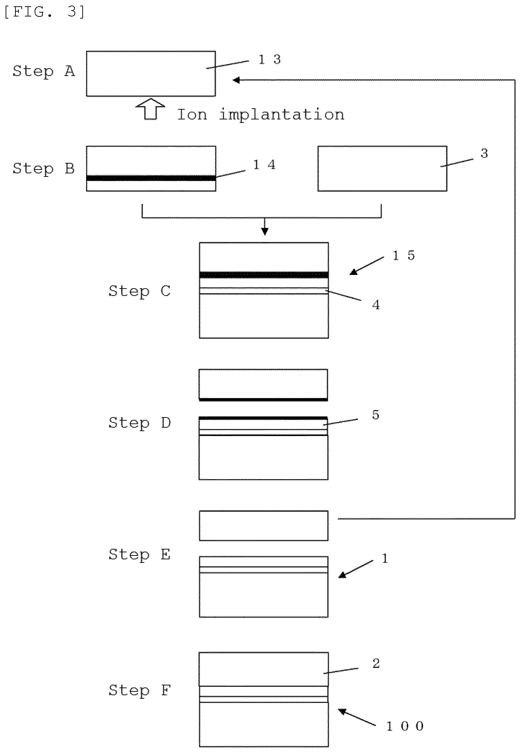

Hereinafter, a method for manufacturing the inventive epitaxial wafer for an ultraviolet ray emission device will be described. The method is largely composed of: a step of manufacturing the laminated substrate 1; and a step of manufacturing the ultraviolet ray emission device layer 2 on the laminated substrate 1. FIG. 3 illustrates an example of the method for manufacturing the inventive epitaxial wafer 100 for an ultraviolet ray emission device.

First, the step of manufacturing the laminated substrate 1 will be described.

A seed substrate 13 (for example, an AlN substrate) of an AlₓGa₁₋ₓN (0.5<x≤1) single crystal is prepared, and ions are implanted from one surface (ion implanting surface) (step A). The ions implanted in this time may be hydrogen ions, noble gas ions, etc., for example. This ion implanting forms a fragile layer (damage layer) 14 to be a peeling position in the seed substrate 13 (step B).

Then, the ion implanting surface of the seed substrate 13 is bonded to an adhesion layer 4 (for example, a SiO₂ layer) formed on a separately prepared first supporting substrate 3 (for example, a synthetic quartz substrate) to form a bonded substrate 15 (step C).

Then, the seed substrate 13 is separated at the fragile layer 14 of the seed substrate 13 in the bonded substrate 15 (step D). According to the above, the AlₓGa₁₋ₓN (0.5<x≤1) single crystal film is thin-film-transferred as the seed crystal layer 5 on the adhesion layer 4 on the first supporting substrate 3 to form the laminated substrate 1 in which the first supporting substrate 3, the adhesion layer 4, and the seed crystal layer 5 are laminated. The surface may be polished, etc., for example, as necessary (step E).

Meanwhile, the remained part of the separated seed substrate 13 can be repeatedly used as a seed crystal layer for producing another laminated substrate by polishing this surface again to form an ion implanting surface.

Next, a step of manufacturing the ultraviolet ray emission device layer 2 (particularly, an epitaxial layer suitable for a light emitting diode for a deep ultraviolet ray region) will be described with reference to FIGS. 2 and 3 (step F).

### [1] Introduction into Reaction Furnace

The laminated substrate 1 is introduced into a reaction furnace of an MOVPE apparatus. Before the laminated substrate 1 is introduced into the reaction furnace, cleaning is performed with a chemical. After the laminated substrate 1 is introduced into the reaction furnace, the furnace is filled with highly pure inert gas, such as nitrogen, to discharge gas in the furnace.

### [2] Step of Cleaning Surface of Laminated Substrate in Furnace

The laminated substrate 1 is heated in the reaction furnace to clean a surface of the substrate. A temperature for cleaning may be decided between 1000°C and 1200°C at a temperature of the laminated substrate surface, and a specifically, clean surface can be obtained by cleaning at 1050°C.

The cleaning is performed after a pressure in the furnace is reduced, and the pressure in furnace may be decided between 200 mbar and 30 mbar. The cleaning is performed for, for example, approximately 10 minutes in a state where mixed gas composed of hydrogen, nitrogen, ammonia, etc. is supplied into the furnace. These conditions are an example, and not particularly limited.

### [3] Step of Growing Homoepitaxial Layer

In this step, gasses to be Al, Ga, and N sources being raw materials are introduced at a predetermined pressure in the furnace and a predetermined substrate temperature, and AlₓGa₁₋ₓN (0.5<x≤1) is epitaxially grown on the laminated substrate 1 (homoepitaxial layer 6).

In this step, the growth may be performed at the pressure in the furnace of 50 mbar and the substrate temperature of 1120°C, for example. Trimethylaluminum (TMAl) as the Al source, trimethylgallium (TMGa) as the Ga source, and ammonia (NH₃) as the N source may be used. To obtain a mixed crystal having a desired Al composition, flow rates of the raw materials, TMAl and TMGa, are set so that a ratio of Al/Ga to be incorporated into the thin film is a set ratio with considering material efficiency of the raw material gases. In this step, AlN may be grown with a flow rate of TMAl of, for example, 0.24 L/min (240 sccm) in a standard state and a flow rate of NH₃ of, for example, 2.0 L/min (2000 sccm). As a carrier gas for TMAl, TMGa, and NH₃, hydrogen may be used, for example. These conditions are an example, and not particularly limited.

### [4] Step of Growing First Conductive Clad Layer

This step is a step of growing a first conductive clad layer 7 on the homoepitaxial layer 6.

In this step, the pressure in the furnace and the substrate temperature in the reaction furnace are held to be predetermined, and then the raw materials, TMAl, TMGa, and NH₃, and impurity gas for n-type conductivity are supplied into the furnace to grow the first conductive clad layer 7. The first conductive clad layer 7 may be freely produced with the composition of the main component represented by Al_{y}Ga_{1-y}N (0.5<y≤1), and may be Al_{0.95}Ga_{0.05}N as an example. A plurality of the layers may be formed with changing the composition.

In this step, the pressure in the furnace may be 75 mbar and the substrate temperature may be 1100°C, for example. To obtain a mixed crystal having a desired Al composition, flow rates of the raw materials, TMAl and TMGa, are set so that a ratio of Al/Ga to be incorporated into the thin film is a set ratio with considering material efficiency of the raw material gases. These values are an example, and not particularly limited.

As the impurity gas for n-type conductivity, monosilane (SiH₄) may be used. As a carrier gas to transport the raw material gases, hydrogen may be used. As the impurity gas, tetraethylsilane may also be used.

### [5] Step of Growing AlGaN-Based Active Layer

This step is a step of growing an AlGaN-based active layer 8 on the first conductive clad layer 7. In this step, the pressure in the furnace and the substrate temperature in the reaction furnace are held to be predetermined, and then the raw materials, TMAl, TMGa, and NH₃, are supplied into the furnace to grow the AlGaN-based active layer 8. The AlGaN-based active layer 8 may be a barrier layer 9: Al_{0.75}Ga_{0.25}N and a well layer 10: Al_{0.6}Ga_{0.4}N as an example. In this step, the pressure in the furnace may be 75 mbar and the substrate temperature may be 1100°C, for example. To obtain a mixed crystal having a desired Al composition in each layer, flow rates of the raw materials, TMAl and TMGa, are set so that a ratio of Al/Ga to be incorporated into the thin film is a set ratio with considering material efficiency of the raw material gases. These values are an example, and not particularly limited.

### [6] Step of Growing Second Conductive Clad Layer

This step is a step of growing a second conductive clad layer 11 on the AlGaN-based active layer 8. In this step, the pressure in the furnace and the substrate temperature in the reaction furnace are held to be predetermined, and then the raw materials, TMAl, TMGa, and NH₃, and an impurity raw material for p-type conductivity are supplied into the furnace to grow the second conductive clad layer 11. The second conductive clad layer 11 may be freely produced with the composition of the component represented by Al_{z}Ga_{1-z}N (0.5<z≤1) , and may be Al_{0.95}Ga_{0.05}N as an example. A plurality of the layers may be formed with changing the composition.

In this step, the pressure in the furnace may be 75 mbar and the substrate temperature may be 1100°C, for example. To obtain a mixed crystal having a desired Al composition, flow rates of the raw materials, TMAl and TMGa, are set so that a ratio of Al/Ga to be incorporated into the thin film is a set ratio with considering material efficiency of the raw material gases. These values are an example, and not particularly limited.

As the impurity raw material for p-type conductivity, biscyclopentadienyl magnesium (Cp₂Mg) may be used. As a carrier gas to transport the raw material gases, hydrogen may be used.

### [7] Step of Growing p-Type AlGaN Contact Layer

This step is a step of growing a p-type AlGaN contact layer 12 on the second conductive clad layer 11. In this step, the pressure in the furnace and the substrate temperature in the reaction furnace are held to be predetermined, and then the raw materials, TMAl, TMGa, and NH₃, and an impurity raw material for p-type conductivity are supplied into the furnace to grow the p-type AlGaN contact layer 12. In this step, the pressure in the furnace may be 75 mbar and the substrate temperature may be 1100°C, for example. These values are an example, and not particularly limited.

As the impurity raw material for p-type conductivity, biscyclopentadienyl magnesium (Cp₂Mg) may be used. As a carrier gas to transport the raw material gases, hydrogen may be used.

### [8] Activating Annealing Step

In this step, the wafer is annealed in a heating furnace at a predetermined temperature and time to activate the p-type impurities in the second conductive clad layer 11 and the p-type AlGaN contact layer 12. The activation in the heating furnace may be performed at 750°C for 10 minutes, for example.

By producing the epitaxial wafer 100 for a light emitting diode for an ultraviolet ray region (particularly, a deep ultraviolet ray region) with the inventive manufacturing method, a substrate with the simple epitaxial layer and few defects due to voids can be obtained, and thereby productivity of the epitaxial steps can be improved.

In addition, the AlN single crystal substrate and the AlGaN single crystal substrate after peel-transferring the seed crystal layer can be recovered and polished again to reuse the expensive compound semiconductor single crystal substrate as the seed substrate and to newly peel-transfer the seed crystal layer, and thereby the epitaxial substrate for a light emitting diode for an ultraviolet ray region can be inexpensively manufactured.

### EXAMPLE

Hereinafter, the present invention will be more specifically described with Example and Comparative Examples, but the present invention is not limited thereto.

### (Example)

An epitaxial wafer for a light emitting diode for deep ultraviolet ray, as illustrated in FIGS. 1 and 2, was manufactured by the inventive manufacturing method as illustrated in FIG. 3. Specifically, the epitaxial wafer was manufactured in steps A to E of manufacturing a laminated substrate and a step F of manufacturing an ultraviolet ray emission device layer (the aforementioned steps [1] to [8]).

On a sapphire substrate, an adhesion layer (planarization layer) composed of SiO₂ was grown with 2 um, and the surface was CMP-processed for planarization. Thereafter, a seed crystal (seed substrate) composed of an AlN single crystal was laminated to the sapphire substrate by normal-temperature bonding to prepare a peel-transferred substrate (laminated substrate).

On the laminated substrate, Al_{0.95}Ga_{0.05}N was grown with 100 nm by an MOVPE method, and n-type Al_{0.95}Ga_{0.05}N was grown with 2.5 um thereon. A quantum well structure composed of three layers in which a barrier layer was Al_{0.75}Ga_{0.25}N and a well layer was Al_{0.6}Ga_{0.4}N was formed thereon. Thereafter, a p-type Al_{0.95}Ga_{0.05}N layer and a p-type GaN contact layer were formed.

In the epitaxial substrate produced in Example, defects were remarkably reduced compared with Comparative Example 1, described later, and a defect density was reduced to 0.32 /cm². Comparative Example 1 needed a step of removing a ceramic substrate, but in Example, ultraviolet light was able to be extracted from the substrate side, and thereby a wafer having good light extraction efficiency was able to be manufactured more inexpensively. In addition, a device having a smaller threading dislocation density and good emission efficiency compared with Comparative Example 2 was able to be manufactured.

### (Comparative Example 1)

On a substrate produced with AlN ceramic, a planarization layer composed of SiO₂ was grown with 2 um, and a seed crystal composed of an Al_{0.95}Ga_{0.05}N single crystal was laminated to prepare a peel-transferred substrate (laminated substrate).

On the laminated substrate, Al_{0.95}Ga_{0.05}N was grown with 100 nm by an MOVPE method, and n-type Al_{0.95}Ga_{0.05}N was grown with 2.5 um thereon. A quantum well structure composed of three layers in which a barrier layer was Al_{0.75}Ga_{0.25}N and a well layer was Al_{0.6}Ga_{0.4}N was formed thereon. Thereafter, a p-type Al_{0.95}Ga_{0.05}N layer and a p-type GaN contact layer were formed.

In the epitaxial substrate produced in Comparative Example 1, defects were generated on the epitaxial substrate due to roughness on the ceramic, and a defect density was 12.2 /cm². In addition, since the ceramic substrate did not transmit deep ultraviolet ray, the produced LED had deteriorated light extraction efficiency compared with Example.

More specifically, the light extraction efficiency was 8% in Example, and 4% or less, approximately 3% in many cases, in Comparative Example 1.

### (Comparative Example 2)

An epitaxial substrate for a light emitting diode for a deep ultraviolet ray region was manufactured by using a sapphire substrate as follows.

### [1] Introduction into Reaction Furnace

A sapphire substrate was introduced into a reaction furnace of an MOVPE apparatus. Before the sapphire substrate was introduced into the reaction furnace, cleaning was performed with a chemical. After the sapphire substrate was introduced into the reaction furnace, the furnace was filled with highly pure inert gas, such as nitrogen, to discharge gas in the furnace.

### [2] Step of Cleaning Sapphire Substrate in Furnace

The sapphire substrate was heated in the reaction furnace to clean a surface of the substrate. The cleaning was performed at a temperature of 1030°C. The pressure in the furnace was 150 mbar. The cleaning was performed for 10 minutes in a state where hydrogen or nitrogen was supplied into the furnace.

### [3] Step of Growing Buffer Layer

In this step, gasses to be Al, Ga, and N sources being raw materials are introduced at a predetermined pressure in the furnace and a predetermined substrate temperature to grow a buffer layer on the sapphire substrate in order to improve crystallinity of the epitaxial layer. A core-forming layer on the substrate and growing conditions were regulated, and low-rate growing layers growing at a low rate and high-rate growing layers were repeated to form a layer to reduce dislocation. To obtain a substrate suitable for an ultraviolet LED, the buffer layer was grown with 3 µm.

An epitaxial substrate for a light emitting diode for a deep ultraviolet ray region was produced under the same conditions as in the step [4] of growing the first conductive clad layer to the step [8] of activating annealing step in Example.

Table 1 shows the results of XRD rocking curve measurement of the epitaxial substrates for a deep ultraviolet ray emitting diode produced in Example and Comparative Examples 1 and 2.

In particular, with comparing the results of Example and Comparative Example 2, FWHM of the XRD rocking curve of AlN (0002) of the epitaxial substrates for a deep ultraviolet ray emitting diode in Example was 43 arcsec, and in contrast, FWHM of Comparative Example 2 was 541 arcsec. Example was able to yield the epitaxial wafer having good crystallinity compared with Comparative Example 2.

As the present invention as above, epitaxial growth on the seed crystal layer formed by laminating can yield the epitaxial wafer having higher crystallinity and high quality.

**[Table 1]**

| | XRD RC AlN (0002) (arcsec) |
|---|---|
| Example | 43 |
| Comparative Example 1 | 55 |
| Comparative Example 2 | 541 |

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. An epitaxial wafer for an ultraviolet ray emission device, comprising:
a first supporting substrate being transparent for ultraviolet ray and having heat resistance;
a seed crystal layer of an AlₓGa₁₋ₓN (0.5<x≤1) single crystal bonded on the first supporting substrate by laminating; and
an epitaxial layer on the seed crystal layer, the epitaxial layer having: a first conductive clad layer containing Al_{y}Ga_{1-y}N (0.5<y≤1) as a main component; an AlGaN-based active layer; and a second conductive clad layer containing Al_{z}Ga_{1-z}N (0.5<z≤1) as a main component that are stacked and grown in this order.

2. The epitaxial wafer for an ultraviolet ray emission device according to claim 1, wherein a main component of the first supporting substrate is synthetic quartz or sapphire.

3. The epitaxial wafer for an ultraviolet ray emission device according to claim 1 or 2, wherein the AlGaN-based active layer is formed with MQW structure and contains In at a proportion of less than 1% as a constituent element other than Al, Ga, and N.

4. The epitaxial wafer for an ultraviolet ray emission device according to any one of claims 1 to 3, wherein the AlGaN-based active layer exhibits a peak wavelength λₚ shorter than 235 nm in an emission spectrum with current injection at 25°C and 0.2 A/mm².

5. The epitaxial wafer for an ultraviolet ray emission device according to any one of claims 1 to 4, wherein a bandgap of the seed crystal layer is larger than a bandgap of the AlGaN-based active layer.

6. The epitaxial wafer for an ultraviolet ray emission device according to any one of claims 1 to 5, wherein an epitaxial growth surface in the seed crystal layer is a C-plane.

7. A method for manufacturing an epitaxial wafer for an ultraviolet ray emission device, the method comprising steps of:
producing a laminated substrate by laminating a seed crystal layer on a first supporting substrate being transparent for ultraviolet ray and having heat resistance, the seed crystal layer being peel-transferred from an AlₓGa₁₋ₓN (0.5<x≤1) single crystal; and
forming an epitaxial layer on the laminated substrate, the epitaxial layer having: a first conductive clad layer containing Al_{y}Ga_{1-y}N (0.5<y≤1) as a main component; an AlGaN-based active layer; and a second conductive clad layer containing Al_{z}Ga_{1-z}N (0.5<z≤1) as a main component that are epitaxially grown in this order.

8. The method for manufacturing an epitaxial wafer for an ultraviolet ray emission device according to claim 7, wherein a main component of the first supporting substrate is synthetic quartz or sapphire.

9. The method for manufacturing an epitaxial wafer for an ultraviolet ray emission device according to claim 7 or 8, wherein the AlGaN-based active layer is formed with MQW structure and contains In at a proportion of less than 1% as a constituent element other than Al, Ga, and N.

10. The method for manufacturing an epitaxial wafer for an ultraviolet ray emission device according to any one of claims 7 to 9, wherein the AlGaN-based active layer exhibits a peak wavelength λₚ shorter than 235 nm in an emission spectrum with current injection at 25°C and 0.2 A/mm² .

11. The method for manufacturing an epitaxial wafer for an ultraviolet ray emission device according to any one of claims 7 to 10, wherein a bandgap of the seed crystal layer is larger than a bandgap of the AlGaN-based active layer.

12. The method for manufacturing an epitaxial wafer for an ultraviolet ray emission device according to any one of claims 7 to 11, wherein an epitaxial growth surface in the seed crystal layer is a C-plane.
